# DEMANDE DE BREVET EUROPEEN

(11) **EP 1 335 486 A1**
(43) Date de publication de la demande: **13.08.2003**
(21) Numéro de dépôt: 03290175.3
(22) Date de dépôt: 23.01.2003
(51) Int. Cl.: H03D 1/18

(54) **Démodulateur pour cartes à puce ou étiquettes sans contact**

(30) Priorité: 24.01.2002 FR 0200899
(71) Demandeur: GEMPLUS, 13420 Gemenos (FR); STMicroelectronics S.A., 92120 Montrouge (FR)
(72) Inventeur: Rizzo, Pierre, c/o Cabinet Ballot, 92593 Levallois-Perret Cedex (FR)
(74) Mandataire: Bentz, Jean-Paul

(57) **Abrégé**

L'invention concerne un démodulateur d'un signal alternatif modulé en amplitude (Vdb), caractérisé en ce qu'il comprend :
- un circuit de détection de crête (10) apte à extraire le signal modulant de référence (Vcrête) du signal modulé (Vdb),
- un premier circuit de translation (12) apte à décaler le niveau du signal modulant de référence (Vcrête) d'une valeur égale à la composante continue (Vdcmod) pour obtenir un signal modulé de référence décalé (Vmod),
- un circuit de génération (14) d'un seuil de comparaison (Vdcmodshift) pour repérer le début et la fin de la modulation,
- un circuit comparateur (16) pour comparer le signal modulé de référence décalé (Vmod) au seuil de comparaison (Vdmodshift) et pour fournir des signaux de franchissement du seuil de comparaison, et
- un circuit d'alimentation non régulée (20) pour fournir une tension d'alimentation (AlimHV) aux différents circuits.

## Description

L'invention concerne un démodulateur d'un signal alternatif modulé en amplitude basé sur le principe de la détection de crête. L'invention concerne également un dispositif de communication sans contact comportant un tel modulateur.

Le démodulateur selon l'invention trouve une application particulièrement avantageuse dans le domaine de la communication par Radio Fréquence (RF) de longue portée. Des dispositifs portables à communication sans contact tels que des cartes à puce sans contact, des étiquettes électroniques ou des badges fonctionnent sur la base d'une communication par champ magnétique avec un organe interrogateur de lecture et/ou écriture appelé communément lecteur. Ces dispositifs sans contact comportent généralement un microcircuit connecté à un circuit résonnant de type L,C parallèle. La bobine d'induction L est une antenne extérieure alors que le condensateur C est intégré au microcircuit. L'ensemble constitue ce qui est communément appelé « circuit d'accord ».

A titre d'exemple, dans certaines applications carte à puce sans contact, le lecteur émet un signal hertzien ayant une fréquence porteuse de 13,56 MHz.

Ce signal émis permet d'une part d'alimenter la carte sans contact qui se procure ainsi l'énergie nécessaire à son fonctionnement par induction, et d'autre part, d'établir une communication entre la carte et le lecteur selon un protocole établi. Ainsi, lorsque la carte sans contact pénètre dans le champ d'émission du lecteur, elle communique avec ce dernier par une opération de modulation qui consiste à modifier au moins un paramètre de la porteuse.

Le dispositif sans contact reçoit de la part du lecteur un signal modulé en amplitude par le biais du circuit d'accord. L'interprétation du message du lecteur par le dispositif sans contact se fait par une opération de démodulation qui consiste à extraire le signal modulé de la porteuse. La fréquence du signal modulé est largement inférieure à celle de la porteuse, en général une dizaine de kHz.

La qualité et la fiabilité de la communication radiofréquence RF sont directement liées, entre autre, à la distance entre le lecteur et le dispositif sans contact. La distance, ou la portée, de la communication RF entre le lecteur et le dispositif sans contact dépend de plusieurs paramètres dont la fréquence d'accord entre le circuit résonnant du dispositif sans contact et la fréquence d'émission du signal du lecteur, ainsi que de la qualité de la démodulation du signal modulé.

La qualité de la démodulation du signal modulé dépend directement de la distance entre le dispositif sans contact et le lecteur ainsi que de la vitesse de déplacement du dispositif dans le champ d'émission du lecteur. Plus la portée est grande et le dispositif furtif, plus la démodulation sera entachée d'erreurs.

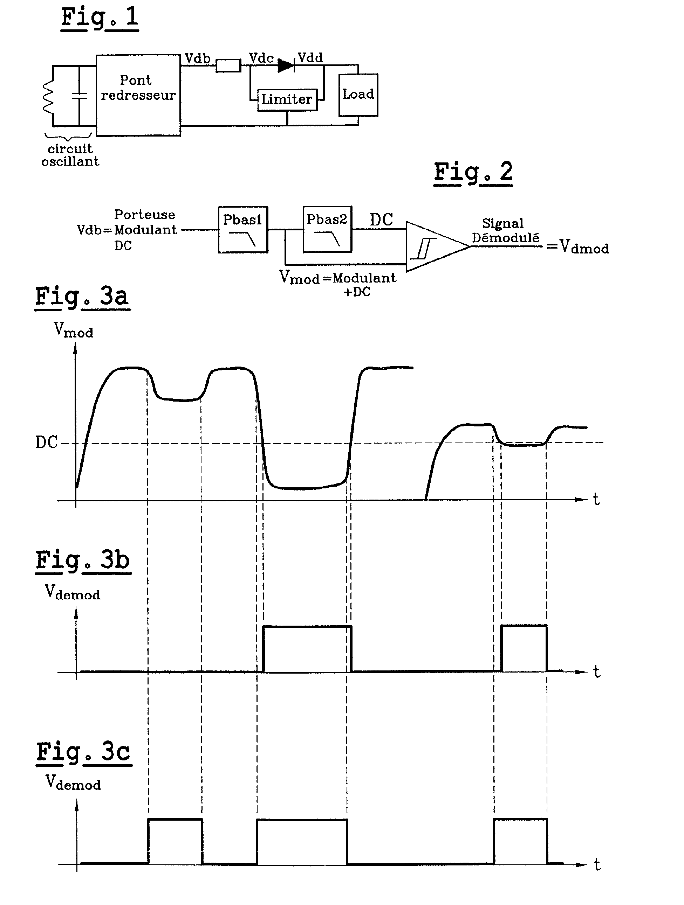

Un schéma bloc des étages d'entrée du dispositif sans contact est illustré sur la figure 1. Un circuit résonant, centré sur la fréquence de la porteuse, reçoit un signal hertzien modulé. Un pont redresseur génère une tension continue afin d'alimenter le dispositif sans contact. La tension à la sortie du pont redresseur Vdb représente la tension directe après redressement et contient à la fois l'énergie nécessaire à l'auto-alimentation du dispositif sans contact et l'information du signal modulé.

Pour des applications utilisant une modulation d'amplitude de 100%, une diode isole le circuit résonant de la charge et élimine ainsi toute possibilité de retour de courant vers le circuit résonant. Un limiteur permet de maintenir la tension d'alimentation Vdd inférieure à un seuil, de 4V par exemple. Une résistance est avantageusement placée entre Vdb et la diode afin d'isoler le signal modulé sur Vdb. Ainsi, la démodulation du signal modulé provenant du lecteur se fait directement à partir du signal Vdb en sortie du pont redresseur du dispositif sans contact.

Un dispositif classique de démodulation en amplitude est illustré schématiquement sur la figure 2.

Le signal Vdb est tout d'abord traité par un filtre passe-bas, de type RC, afin d'éliminer les composantes de la porteuse pour en retirer d'une part l'enveloppe du signal modulé, que l'on appelle communément le signal modulant de référence Vmod, et d'autre part sa composante continue DC. Une fréquence de coupure de quelques dizaines de kHz peut être choisie pour ce premier filtre. Le niveau continu DC est ensuite extrait par un nouveau filtre passe-bas dont la fréquence de coupure est inférieure à la fréquence du signal modulant Vmod, quelques kHz par exemple. Le signal de démodulation Vdemod peut alors être obtenu par comparaison entre le signal modulant de référence Vmod et son niveau continu DC.

Un tel dispositif de démodulation présente des limitations dues à sa structure même. En effet, le niveau continu DC est largement variable en fonction du positionnement de la carte dans le champ du lecteur, et de sa vitesse de déplacement. Cet état de fait rend la génération d'un niveau de comparaison fiable difficile à obtenir de façon permanente. Ce problème est même accentué pour des applications où une grande portée, 50cm à 1m environ, est requise.

Les graphes des figures 3a à 3c illustrent les limites des dispositifs classiques de démodulation.

Le signal modulant de référence Vmod est reporté sur la figure 3a avec son niveau continu DC. Le signal de démodulation Vdemod est reporté sur la figure 3b. On constate que certaines modulations peuvent ne pas être détectées et que les modulations identifiées par le dispositif ne le sont pas parfaitement, c'est-à-dire que le début et la fin de la modulation ne sont pas précisément repérés.

La figure 3c illustre à cet effet l'objectif de la présente invention qui consiste à réaliser, pour un dispositif sans contact, un démodulateur capable de repérer avec précision le début et la fin de tous les signaux modulés émis par le lecteur.

Pour pallier ces inconvénients, la demanderesse a décrit, dans la demande de brevet N° 00 03606 déposée le 25 mars 2000, un démodulateur dit "actif" basé sur le principe de la détection de crête et de creux. Ce démodulateur actif est apte à générer, en suivant le signal modulé de façon dynamique, un seuil bas et un seuil haut qui permettent de repérer précisément le début et la fin de la modulation.

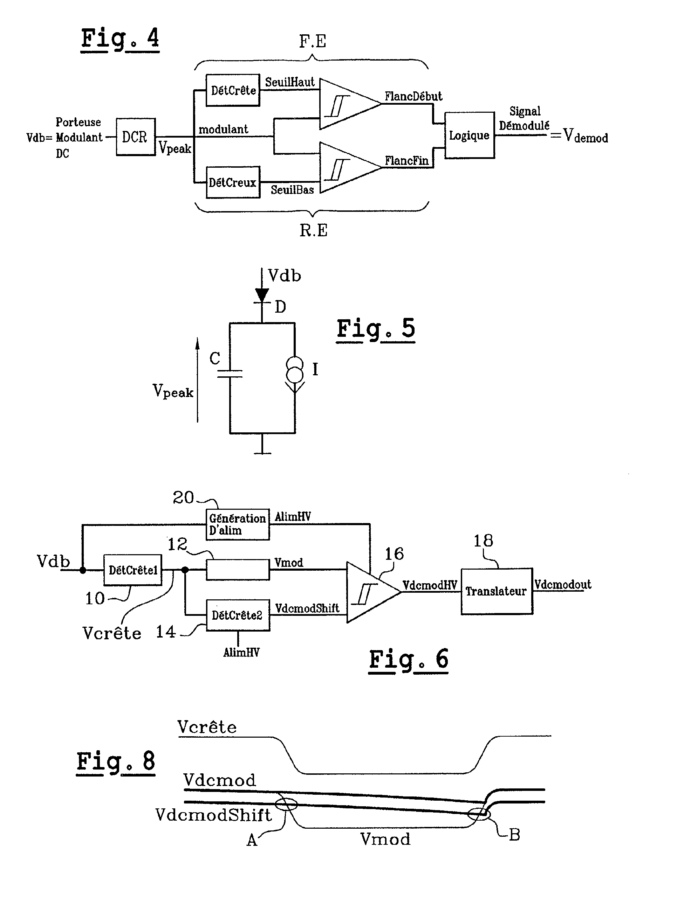

Un tel modulateur est principalement constitué de deux démodulateurs indépendants F.E. et R.E. (figure 4), respectivement optimisés pour détecter le début et la fin du signal modulé.

Ce démodulateur comprend :
- une cellule de détection de crête DCR apte à extraire le signal modulant de référence Vpeak1 du signal modulé Vdb ;
- un premier démodulateur FE apte à détecter la crête du signal modulant de référence Vpeak pour générer un seuil haut de comparaison et repérer le début de la modulation ;
- un second démodulateur RE apte à détecter un creux du signal modulant de référence Vpeak pour générer un seuil bas de comparaison et repérer la fin de la modulation, et
- une unité de traitement logique apte à fournir le signal démodulé Vdemod.

A cet effet, on réalise une détection de crête à partir d'une cellule de base schématisée sur la figure 5. Une telle cellule se compose essentiellement d'une diode D, d'un condensateur C et d'une source de courant continu I, et permet d'extraire le signal modulant de référence Vpeak du signal modulé Vdb.

Lorsque l'on considère un signal modulé Vdb double alternance, le condensateur C ne peut chargé que pendant l'alternance positive de Vdb, c'est-à-dire quand Vdb-Vpeak>Vd, avec Vd la tension de seuil de la diode. Dès que cette relation n'est plus vérifiée, la diode de la cellule de base se bloque et le condensateur C a un effet mémoire, c'est-à-dire qu'à l'instant du blocage de la diode, on a très précisément Vpeak=Vdb (crête)-Vd. Le condensateur C est ensuite déchargé à courant constant et Vpeak diminue selon la relation dVpeak/dt=i/C.

Il faut par conséquent choisir une constante de temps adaptée pour récupérer le signal modulé sans atténuation tout en limitant la résultante due à la porteuse. En effet, la fréquence du signal modulé est lente par rapport à celle de la fréquence.

Le démodulateur à détection de crête et de creux qui vient d'être décrit présente une dynamique d'entrée qui est limitée par celle du comparateur qui est comprise entre [Vtn-Vdd]. Or, le niveau utile sur le signal Vdb peut atteindre des tensions de 12 volts alors que la tension Vdd d'alimentation du comparateur est généralement régulée entre 3 et 5 volts. Il en résulte des "trous de communication" qui apparaissent à couplage élevé avec le lecteur.

Un but de la présente invention est un démodulateur d'un signal alternatif modulé en amplitude qui ne présente pas de trou de communication.

Ce but est atteint d'une part en utilisant des détecteurs de crête et un comparateur pour détecter le début et la fin de la modulation et, d'autre part, en alimentant lesdits détecteurs de crête et le comparateur par une tension d'alimentation non régulée. L'invention concerne donc un démodulateur d'un signal alternatif modulé en amplitude, caractérisé en ce qu'il comprend :
- un circuit de détection de crête apte à extraire le signal modulant de référence Vcrête du signal modulé Vdb,
- un premier circuit de translation apte à décaler le niveau du signal modulant de référence Vcrête d'une valeur égale à la composante continue Vdcmod pour obtenir un signal modulé de référence décalé Vmod,
- une circuit de génération d'un seuil de comparaison Vdcmodshift pour repérer le début et la fin de la modulation,
- un circuit comparateur pour comparer le signal modulé de référence décalé Vmod au seuil de comparaison Vdcmodshift et pour fournir des signaux de franchissement du seuil de comparaison, et
- un circuit d'alimentation non régulée pour fournir une tension d'alimentation AlimHV aux différents circuits.

Ce démodulateur comprend, en outre, un deuxième circuit de translation 18 apte à décaler le niveau des signaux fournis par le comparateur 16 à la valeur Vdd de l'alimentation régulée.

D'autres caractéristiques et avantages de la présente invention apparaîtront à la lecture de la description suivante d'un exemple particulier de réalisation, ladite description étant faite en relation avec les dessins joints dans lesquels :
- la figure 1, déjà décrite, est un schéma fonctionnel des circuits d'entrée d'un dispositif de communication sans contact,
- la figure 2, déjà décrite, est un schéma fonctionnel montrant un circuit de démodulation d'un signal alternatif modulé en amplitude,
- les figures 3a, 3b et 3c, déjà décrites, sont des courbes illustrant, respectivement, le signal modulé et son niveau continu, le signal démodulé à l'aide d'un dispositif classique et le signal démodulé à l'aide d'un modulateur selon le schéma de la figure 4,
- la figure 4 est un schéma d'un démodulateur à détection de crête et de creux tel que décrit dans la demande de brevet N° 00 03606 déposée le 25 mars 2000,
- la figure 5 est un schéma de principe d'un circuit de détection de crête,
- la figure 6 est un schéma fonctionnel d'un démodulateur d'un signal modulé en amplitude selon la présente invention,
- la figure 7 est un schéma détaillé du démodulateur selon la présente invention,
- la figure 8 illustre de manière schématique les différentes tensions à différents points des schémas des figures 6 et 7,
- la figure 9 illustre le signal haute fréquence modulé en amplitude Vdb, et
- la figure 10 illustre les courbes de différents signaux à différents points du démodulateur selon la présente invention.

Dans la description qui suit, il est fait référence à une carte de communication sans contact recevant d'un lecteur de carte un signal alternatif modulé en amplitude dont la fréquence porteuse est 13,56 Mhz et l'index de modulation de 10 %. L'application requiert une portée de la communication radiofréquence pouvant atteindre un mètre pour une vitesse de déplacement de la carte dans le champ magnétique du lecteur pouvant atteindre 3m/s.

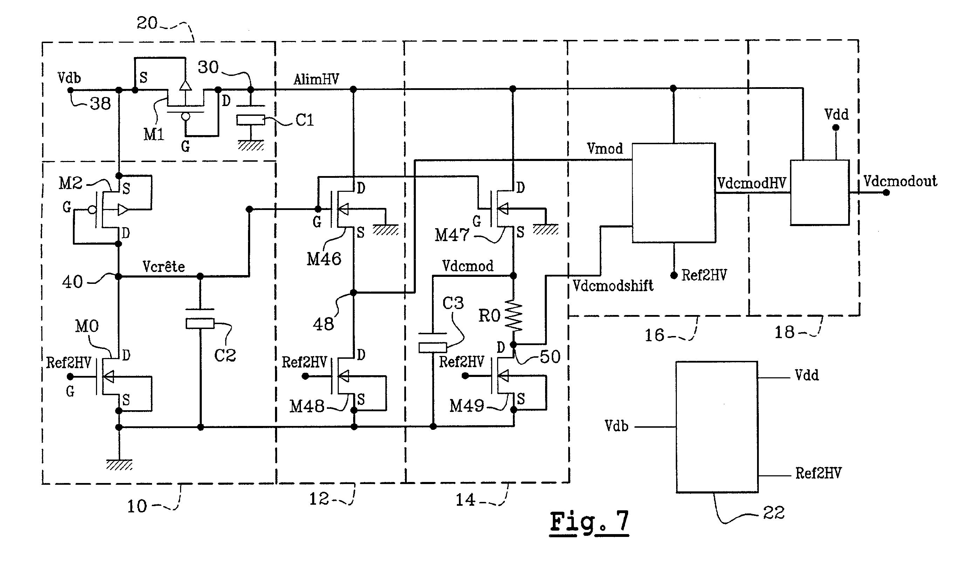

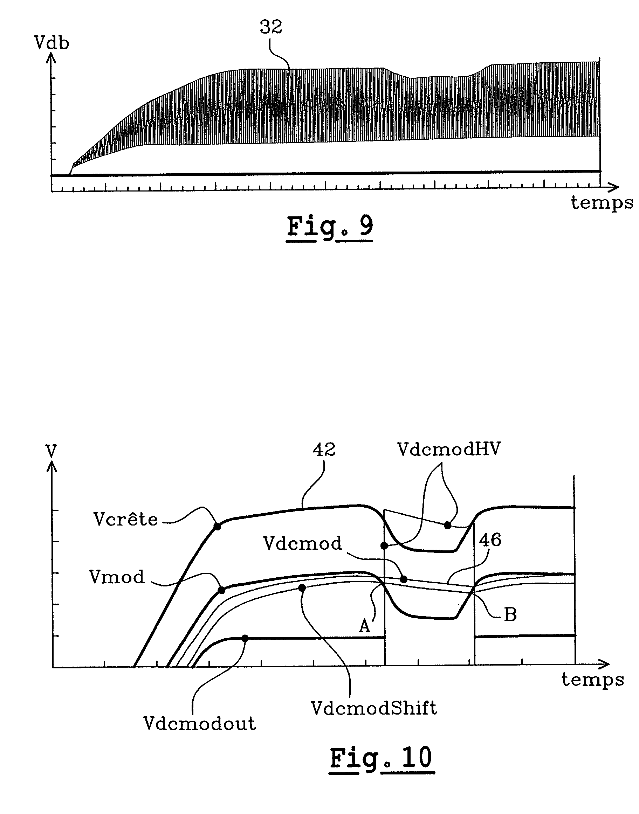

Selon le schéma fonctionnel de la figure 6, le démodulateur selon l'invention comprend :
- un circuit de détection de crête 10 (DétCrête
   1) qui reçoit sur sa borne d'entrée un signal haute fréquence (13,56 Mhz) modulé en amplitude Vdb (figure 9) et qui fournit sur sa borne de sortie un signal modulant de référence Vcrête qui constitue l'enveloppe du signal Vdb ;
- un premier circuit de translation 12 qui reçoit sur sa borne d'entrée le signal Vcrête et qui fournit sur sa sortie un signal Vmod qui est le signal Vcrête décalé de la composante continue Vdcmod ;
- un circuit de génération 14 d'un seuil de comparaison Vdcmodshift qui reçoit sur sa borne d'entrée le signal Vcrête et qui fournit sur sa borne de sortie le signal Vdcmodshift qui est le signal de la composante continue Vdcmod décalé d'une certaine valeur ;
- un circuit comparateur 16 qui reçoit sur une première entrée le signal de seuil Vdcmodshift fourni par le circuit générateur 14 et sur une deuxième entrée le signal Vmodul fourni par le premier circuit de translation 12 ; ce circuit comparateur fournit sur sa borne de sortie un signal VdcmodHV qui commence lorsque le signal Vmodul devient inférieur au seuil Vdcmodshift (point A) et qui finit lorsque le signal Vmod devient supérieur au seuil Vdcmodshift (point B) ;
- une deuxième circuit de translation 18 qui reçoit sur sa borne d'entrée le signal VdcmodHV fourni par le circuit comparateur 16 et qui fournit sur sa borne de sortie un signal Vdcmodout qui résulte du décalage du signal VdcmodHV vers le niveau Vdd correspondant à une tension d'alimentation régulée fournie par un circuit d'alimentation 22 (figure 7), et
- un circuit d'alimentation non régulée 20 qui reçoit sur sa borne d'entrée le signal modulé Vdb et qui fournit sur sa borne de sortie une tension d'alimentation non régulée AlimHV, cette tension AlimHV étant appliquée aux différents circuits ci-dessus si besoin est, et en particulier, aux circuits 12, 14, 16 et 18.

L'utilisation pour les circuits du démodulateur selon l'invention d'une tension d'alimentation non régulée AlimHV permet de bénéficier sans limitation de toute la dynamique du signal modulé Vdb et notamment de détecter un signal modulé de très grande amplitude dû, par exemple, à la proximité immédiate du lecteur de carte, signal de grande amplitude qui conduirait dans un démodulateur de l'art antérieur à un trou de communication (figure 3-b).

La figure 7 est un schéma détaillé de réalisation de certains des circuits du schéma de la figure 6, savoir les circuits référencés 10, 12, 14 et 20.

Le circuit d'alimentation non régulée 20 comprend un transistor MOS du type P (PMOS) M1 monté en diode par la connexion des électrodes de drain et de grille. Le drain du transistor M1 est connecté à la borne de masse via un condensateur de découplage C1 qui sert à réguler la tension au point 30 pendant la durée d'un signal de modulation Vdb appliqué au point 38 sur la source du transistor M1. Le signal Vdb de modulation est montré par la courbe 32 de la figure 9. La tension d'alimentation Alimhv est prise au point 30 et alimente les autres circuits 12, 14, 16 et 18.

Le circuit de détection de crête 10 réalise une détection de crête en tête du démodulateur pour extraire un signal de référence Vcrête à partir du signal d'antenne Vdb qu'il reçoit sur la source d'un transistor PMOS M2 monté en diode par la connexion des électrodes de grille et de drain.

Le drain du transistor M2 est connecté à la masse via un circuit comprenant en parallèle un transistor NMOS MO et un condensateur C2. Le signal Vcrête, pris au point 40, est montré par la courbe 42 de la figure 10.

La constante de temps réalisée par le transistor MO et le condensateur C2 est suffisamment petite pour récupérer le maximum de la modulation du signal Vdb.

Le signal Vcrête est appliqué au circuit de translation 12 qui fournit le signal Vmod et au circuit générateur de seuil de comparaison 14 qui fournit le signal Vdcmod.

Les circuits 12 et 14 sont analogues en ce sens qu'ils comprennent chacun un transistor suiveur M46 ou M47 polarisé par un transistor de recopie M48, M49. Le transistor suiveur M46 ou M47 est du type NMOS dont le drain est connecté à la tension d'alimentation Alimhv et dont la grille reçoit la tension Vcrête. Le transistor de recopie M48 ou M49 est également du type NMOS dont le drain est connecté à la source du transistor suiveur M46 ou M47. La grille du transistor de recopie 48 ou 49 est connectée à une tension de référence Ref2HV tandis que la source est connectée à la masse.

Le transistor de recopie M49 est monté en parallèle avec un condensateur C3 de manière à introduire une constante de temps sur le signal Vmod et obtenir le signal Vdcmod (courbe 46 - figure 9).

Quand le condensateur C3 est déchargé et en l'absence de modulation, M47 charge le condensateur à la valeur Vdcmod # Vcrête-Vgs # Vmod.

Lors d'une chute de niveau sur Vcrête, Vmod est mémorisé par le condensateur C3 de sorte que Vcrête-Vgs<Vdcmod, ce qui bloque le transistor M47. Le condensateur C3 est déchargé par le courant de polarisation de M47 tant que Vcrête-Vgs<Vmod.

La décharge du condensateur C3 est lente par rapport à la modulation mais doit être plus rapide qu'une baisse possible de la tension d'alimentation alimhv lorsque la carte s'éloigne du lecteur.

Le signal Vdcmod repère la crête du signal de modulation Vmod pour créer un seuil de comparaison par un décalage de niveau en utilisant la chute de potentiel à travers une résistance R0 connectée entre le drain du transistor M49 et la source du transistor M48.

En fin de modulation, le transistor M47 redevient passant quand Vcrête-Vgs>Vdcmod, de sorte que le condensateur C3 se recharge et Vdcmod#Vmod avec Vmod recroisant Vdcmodshift.

Il en résulte un croisement de Vmod et de Vdcmodshift en début et fin de modulation.

Afin d'assurer une concordance prévue des signaux Vmod et Vdcmod lors d'une crête du signal de modulation, les couples de transistors M46, M47 et M48, M49 sont appairés.

Le comparateur 16 est du type à hystérésis et comprend des transistors supportant des tensions élevées. Il présente, par exemple, une hystérésis de 50mV pour éliminer de possibles transitions multiples dues à la composante résiduelle du signal à la fréquence porteuse. Les seuils de déclenchement sont alors de 250 mV en début de modulation et 150 mV en fin de modulation.

Le signal de sortie VdcmodHV du comparateur 16 a une excursion comprise entre la tension d'alimentation Alimhv et la masse. Il est appliqué à un circuit de translation 18 qui comprend par exemple un circuit inverseur alimenté par Vdd qui accepte le signal VdcmodHV en entrée et fournit un signal Vdcmodout dont l'excursion est comprise entre Vdd et la masse.

## Revendications

1. Démodulateur d'un signal alternatif modulé en amplitude (Vdb), **caractérisé en ce qu'**il comprend :
- un circuit de détection de crête (10) apte à extraire le signal modulant de référence (Vcrête) du signal modulé (Vdb),
- un premier circuit de translation (12) apte à décaler le niveau du signal modulant de référence (Vcrête) d'une valeur égale à la composante continue (Vdcmod) pour obtenir un signal modulé de référence décalé (Vmod),
- une circuit de génération (14) d'un seuil de comparaison (Vdcmodshift) pour repérer le début et la fin de la modulation,
- un circuit comparateur (16) pour comparer le signal modulé de référence décalé (Vmod) au seuil de comparaison (Vdmodshift) et pour fournir des signaux de franchissement du seuil de comparaison, et
- un circuit d'alimentation non régulée (20) pour fournir une tension d'alimentation (AlimHV) aux différents circuits.

2. Démodulateur selon la revendication 1, **caractérisé en ce qu'**il comprend, en outre, un deuxième circuit de translation (18) apte à décaler le niveau des signaux fournis par le comparateur (16) pour les adapter à une tension d'alimentation différente.

3. Démodulateur selon la revendication 1 ou 2, **caractérisé en ce que** le premier circuit de translation (12) comprend en série :
- un transistor suiveur (M46) qui reçoit sur sa grille le signal modulé de référence (Vcrête), son drain étant connecté à la tension d'alimentation (AlimHV), et
- un transistor de polarisation (M48) dont la grille est à un potentiel de référence (Rf2HV), le drain connecté à la source du transistor suiveur (M46), et la source connectée au potentiel de masse,
- le signal de sortie (Vmod) étant pris au point commun (48) de la source du transistor suiveur (M46) et du drain du transistor de polarisation ((M48).

4. Démodulateur selon l'une des revendications précédentes 1 à 3, **caractérisé en ce que** le circuit de générateur du seuil de comparaison (Vdcmodshift) comprend :
- un transistor suiveur (M47) qui reçoit sur sa grille le signal modulé de référence (Vcrête), le drain étant connecté à la tension d'alimentation non régulée (AlimHV), et
- un transistor de polarisation (M49) dont la grille est à un potentiel de référence (Rf2HV), le drain connecté à la source du transistor suiveur (M47) via une résistance RO et la source connectée au potentiel de masse, la source du transistor suiveur étant connectée au potentiel de masse via un condensateur C3,
- le signal de sortie (Vdcmodshift) étant pris sur le drain du transistor de polarisation (M49).
